# EUROPEAN PATENT APPLICATION

(11) **EP 3 179 599 A1**
(43) Date of publication of application: **14.06.2017**
(21) Application number: 16202716.3
(22) Date of filing: 07.12.2016
(51) Int. Cl.: H02J 9/06

(54) **DUAL-SOURCE POWER SUPPLY**

(30) Priority: 07.12.2015 US 201514960820
(71) Applicant: Hamilton Sundstrand Corporation, Charlotte, NC 28217-4578 (US)
(72) Inventor: Dickey, John A., Rockford, IL 61109 (US)
(74) Representative: Bridge, Kerry Ann

(57) **Abstract**

A power supply for providing power to a load includes an alternating current (AC) power supply (202) having a positive output and a negative output connected to a common ground; a direct current (DC) power supply (204) connected to a same common ground as the AC power supply (202); a rectifier (206) connected to an output of the AC power supply (202) and the common ground that converts AC power to DC power an provides to an output (208) of the power supply; a connection control circuit coupled between the DC power supply (204) and the output that connects the DC power supply to the output when the AC power supply (202) is inactive.

## Description

### TECHNICAL FIELD

The present disclosure generally relates to power systems, and more particularly, to providing both A.C. and D.C. to a load.

### BACKGROUND

In some cases, dual power sources, one A.C. and one D.C. may be used to power a load. The A.C. supply may be provided to the load through a rectifier and the D.C. provided as a backup.

For example, in an aircraft, a generator driven by rotation of the turbine may provide A.C. power to a rectifier that converts the A.C. power to D.C. power and then provides it to the load. The aircraft may also include backup power supplies in the form of batteries or other electrical storage devices. These backup supplies can provide power when other sources fail or the turbine is not operating (e.g., while the aircraft is on the ground).

### SUMMARY

According to one embodiment, a power supply for providing power to a load is disclosed. The power supply includes an alternating current (AC) power supply having a positive output and a negative output connected to a common ground; a direct current (DC) power supply connected to a same common ground as the AC power supply; a rectifier connected to an output of the AC power supply and the common ground that converts AC power to DC power an provides to an output of the power supply; a connection control circuit coupled between the DC power supply and the output that connects the DC power supply to the output when the AC power supply is in active.

Also disclosed is a method of supplying power to a load. The method includes providing an alternating current (AC) power supply; providing a direct current (DC) power supply; connecting the AC power supply and the DC power supply to a common ground; providing a rectifier between the AC power supply and the load; coupling, through a connection control circuit, a positive output of the DC supply to the load; providing power from the AC power supply only to the load when the AC power supply is active; and providing power from the DC power supply only to the load when the AC power supply is not active.

### BRIEF DESCRIPTION OF THE DRAWINGS

The subject matter which is regarded as the invention is particularly pointed out and distinctly claimed in the claims at the conclusion of the specification. The foregoing and other features, and advantages of the invention are apparent from the following detailed description taken in conjunction with the accompanying drawings in which:
FIG. 1 is a functional diagram of a dual-source DC supply system according to the prior art; and
FIG. 2 a functional diagram of a dual-source DC supply system according to one embodiment of the present invention.

### DETAILED DESCRIPTION

Various embodiments provide a dual-source DC power supply that utilize a diode to switch where the input is provided by an AC or DC source. In certain embodiments, both the AC and DC sources share a common ground.

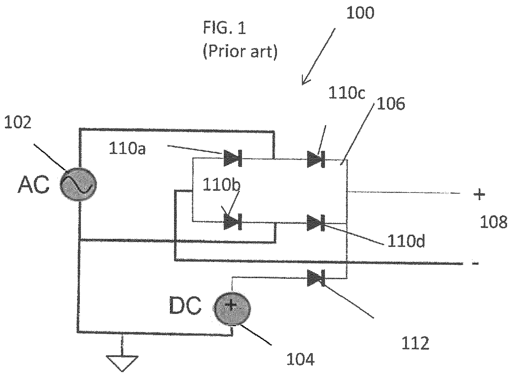

FIG. 1 shows one manner in which a dual source power supply 100 may provide power to an output. The supply 100 includes an AC power source 102 and a DC power supply 104. The AC power source 102 may be any type of supply and include any type of generator or AC power supply. The DC power source 104 may be a source of rectified power or may only produce DC power (e.g. a battery). In operation, the AC power source 102 provides AC power to a full wave rectifier 106. As shown, the rectifier 106 includes 4 diodes 110a, 110b, 110c, 110d. Of course, other types of rectification circuits may be used. The rectifier 106 provides substantially DC power to output 108.

At times it may be beneficial to provide a back-up or alternative power source. Examples include, providing power when the source of A.C. power is not present. During such times it may be beneficial to have the DC power source 104 provide the power. Also, if the AC power supply 102 fails, the DC power supply 104 may need to provide power to load/output 108 though DC diode 112.

As illustrated, the AC source 102 and the DC source 104 are both physically connected to the output at the same time. In addition, both sources 102, 104 share a common ground. Such a system allows for less wiring and ensures that the two systems need not be isolated. Diode 112 allows for current to flow from the DC source 104 if the output voltage at output 108 falls below the output level of the DC source 104. This means that, in general, during operation, as long as the AC source 102 and bridge 106 produce an output voltage that is greater than the output of the DC source 104, only the AC source 102 is providing power. That is, if AC source 102 fails, DC source 104 will take over. In common terms, the diodes in bridge 106 and 112 are diode "OR-ing" the two power supplies together.

When the two power supplies are effectively diode OR'd as shown FIG. 1, during the negative half cycle of the AC power source 102, voltage from the DC diode 112 will be higher than the voltage from diode 110d and will source current which will result in the AC negative half cycle current flowing from the DC power source, through diode 112, through the load 108, and back to the AC source through diode 110a. This is only true when the two supplies 102, 104 have a common reference to ground (non-isolated).

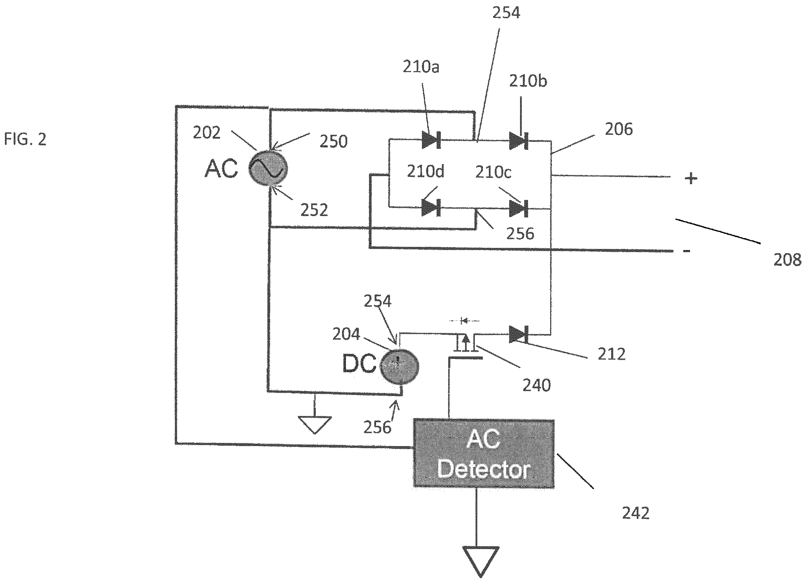

FIG. 2 shows an embodiment of the present invention. In this embodiment, a switch 240 is placed in series with the DC power source 204.

In more detail, this embodiment includes an AC power source 202 and a DC power supply 204 connected to a common ground. The AC power source 202 has two outputs, 250 and 252. The first output 250 is connected to a first input 254 of rectifier 206 and the second output 252 in connected to a second input 256 of the rectifier 206.

The AC power source 202 may be any type of supply or include any type of generator that may be coupled to rotary shaft of an aircraft. Such shafts may be connected to the engines or turbine or the RAM air fan, for example. In operation, the AC power source 202 provides AC power to a full wave rectifier 206. The second output 252 of the AC power source 202 is connected to both the second input of the rectifier 206 and to a common ground. As shown, the rectifier 206 includes 4 diodes 210a, 210b, 210c, 210d. Of course, other types of rectification circuits may be used. The rectifier 206 provides substantially DC power to load/output 208.

The DC power source 204 may be a source of rectified power or may only produce DC power (e.g. a battery). The DC power source 204 includes a positive output 254 and a negative output 256 that is connected to the common ground. That is, the AC and DC power sources 202, 204 are connected to same, common ground. The positive output 254 is connected through switch 240 and diode 212 to the load 208.

If the AC power supply 202 fails, the DC power supply 204 may need to provide power to load/output 208 though DC diode 212. To that end, an AC detector 242 is provided that determines if the AC supply 202 has failed. If it has, then switch 240 is closed and the DC power 204 is provided power to the load 208. The combination of the switch 240, detector 242 and the diode 212 (or subcombinations thereof) may be referred to as connection control circuit herein.

As shown, the switch 240 is a P-channel FET but other types of switches, such as N-Type FETs may be used. Of course, additional types of switches may also be used. The switch 240 isolates the output of the DC source 204 from flowing back to the AC source 204 during negative half-cycles.

As discussed above, in a case where AC and DC supplies share a common ground, provided switch 240 blocks cross current flow between the AC and DC power supplies 102, 104 during the times when both are active. This results in an even balanced positive and negative half cycle to the load when the AC power source 202 is active and is safer in the fact that AC current is not coupled through the DC power source 204.

While the invention has been described in detail in connection with only a limited number of embodiments, it should be readily understood that the invention is not limited to such disclosed embodiments. Rather, the invention can be modified to incorporate any number of variations, alterations or substitutions not heretofore described, but which are commensurate with the scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

## Claims

1. A power supply for providing power to a load comprising:
an alternating current (AC) power supply (202) having a positive output and a negative output connected to a common ground;
a direct current (DC) power supply (204) connected to a same common ground as the AC power supply;
a rectifier (206) connected to an output of the AC power supply (202) and the common ground that converts AC power to DC power and provides to an output of the power supply; and
a connection control circuit coupled between the DC power supply and the output that connects the DC power supply to the output (208) when the AC power supply is inactive.

2. The power supply of claim 1, wherein the connection circuit includes a switch (240) and a diode (212) connected in series between a positive output (254) of the DC source and a positive terminal of the output.

3. The power supply of claim 1 or 2, wherein the connection circuit further includes:
an AC detector (242) that determines the AC power supply (202) as is inactive.

4. The power supply of claim 2 or 3, wherein the AC detector (242) causes the switch (240) to allow for conduction though the diode (212) when the AC power supply (202) is inactive.

5. The power supply of claim 2, 3 or 4, wherein the switch (240) is a P-FET.

6. A method of supplying power to a load comprising:
providing an alternating current (AC) power supply (202);
providing a direct current (DC) power supply (204);
connecting the AC power supply (202) and the DC power supply (204) to a common ground;
providing a rectifier (206) between the AC power supply (202) and the load;
coupling, through a connection control circuit, a positive output of the DC supply (204) to the load;
providing power from the AC power supply (202) only to the load when the AC power supply (202) is active; and
providing power from the DC power supply (204) only to the load when the AC power supply (202) is inactive.

7. The method of claim 6, wherein the connection circuit includes a switch (240) and a diode (212) connected in series between a positive output (254) of the DC source and a positive terminal of the output.

8. The method of claim 6 or 7, wherein the connection circuit further includes:
an AC detector (242) that determines whether the AC power supply (202) is active or inactive.

9. The method of claim 8, wherein the AC detector (242) causes the switch (240) to allow for conduction thought the diode (212) when the AC power supply (202) is inactive.

10. The method of claim 7, 8 or 9, wherein the switch (240) is a P-FET.
